**Europäisches Patentamt**

**European Patent Office**

**Office européen des brevets**

(19)

(11) Publication number : **0 403 561 B1**

(12)

# EUROPEAN PATENT SPECIFICATION

(45) Date of publication of patent specification :
**19.04.95 Bulletin 95/16**

(51) Int. Cl.[6] : **G21K 1/02**

(21) Application number : **89904172.7**

(22) Date of filing : **13.03.89**

(86) International application number :
**PCT/GB89/00256**

(87) International publication number :
**WO 89/08920 21.09.89 Gazette 89/23**

(54) **OPTICAL DEVICES AND METHODS OF FABRICATION THEREOF.**

(30) Priority : **11.03.88 GB 8805776**
**08.07.88 GB 8816374**
**30.12.88 GB 8830403**

(43) Date of publication of application :
**27.12.90 Bulletin 90/52**

(45) Publication of the grant of the patent :
**19.04.95 Bulletin 95/16**

(84) Designated Contracting States :
**AT CH DE FR IT LI NL SE**

(56) References cited :
**US-A- 4 028 547**

(73) Proprietor : **ROSSER, Roy Jonathan**
**238 Hammersmith Grove**
**London W6 7EW (GB)**

(72) Inventor : **ROSSER, Roy Jonathan**
**238 Hammersmith Grove**
**London W6 7EW (GB)**

(74) Representative : **Cullis, Roger et al**
**Patents Department**
**British Technology Group Ltd**
**101 Newington Causeway**
**London SE1 6BU (GB)**

EP 0 403 561 B1

## Description

This invention relates to optical components and methods of manufacture thereof. It finds particular application in the fabrication of grazing incidence mirrors used in x-ray lithography to match the profile and shape of the emitted radiation to that required by the lithographic masks.

Synchrotrons are devices which are becoming increasingly popular as intense sources of x-ray radiation. They are used in the semiconductor industry as radiation sources for x-ray lithography for large-scale production of patterns with sub-micron features. The radiation produced by synchrotrons has a large angular divergence in the horizontal plane (the plane of the electron orbit) but a very small divergence in the vertical plane. Typical values are 20 mRadians in the horizontal and 1 mRadian in the vertical. This means that if allowed to expand naturally, the beam will illuminate a narrow rectangle of the order of 200mm by 10mm at a distance of 10 metres. For x-ray lithography the ideal illumination patch is a square 50mm by 50mm. Other workers have produced this in three different ways. In the first a flat or cylindrical mirror is placed about 3m from the tangent point (effective source of radiation). The mirror is then scanned in the vertical direction. The disadvantages of this method are that a moving part has to be introduced into a high vacuum region and that the area has to be overscanned in order to produce sufficiently uniform illumination. This overscanning means that less than 50% of the available radiation is used for exposing the lithographic pattern. A second method that has been used is to tilt the orbit of the electron beam within the synchrotron. Although this has the advantage of no moving parts, it affects all beam ports on the synchrotron and may also introduce safety problems. The third possibility of scanning a silicon wafer that is being illuminated is impractical in a manufacturing environment because of the size of the mask and wafer alignment systems.

We have found that, by using grazing incidence optics that shape the synchrotron radiation to the required dimensions, difficulties of the prior art methods may be overcome. This option has previously been ignored partly because the mirrors were thought to be too costly to produce. However by approximating the ideal conics of revolution by various types of toroidal mirror, and then producing the required toroidal surfaces by bending cylindrical mirrors (which may be sections of mass produced glass tubing), a workable solution that is very cost effective is possible.

According to the present invention there is provided an optical device adapted for use as a grazing incidence collimator including at least one reflective surface of saddle-toroid form.

There is also provided a method of manufacture of optical components characterised in that it comprises the steps of forming a base member comprising a concave cylindrical substrate having a surface layer divided into an array of linear strip-like members perpendicular to the axis of said cylindrical substrate, applying heat to melt the surface layer and applying a reflective coating to said surface layer.

The invention will now be specifically described with reference to the accompanying drawings, in which:-

| Figure 1 | shows a saddle-toroid mirror; |
|---|---|
| Figure 2 | shows a section of tube being bent by couples applied at either end; |
| Figure 3 | shows the profile of illumination; |
| Figure 4 | shows a schematic elevation of an embodiment of the invention employing a single mirror; |
| Figure 5 | shows a schematic plan view of this embodiment; |
| Figure 6 | shows a schematic side elevation of an embodiment employing two mirrors; |
| Figure 7 | shows a schematic end elevation of the mirror; |
| Figure 8 | shows a schematic plan view of the mirrors; |
| Figure 9 | shows a schematic side elevation of an alternative embodiment employing two mirrors; |
| Figure 10 | shows a schematic end elevation of the mirror; and |
| Figure 11 | shows a schematic plan view of the mirrors. |
| Figure 12 | shows a cross section of the micro toroid array before heating; |
| Figure 13 | shows a cross section of the micro toroid array after heating; |
| Figure 14 | shows, in cross section a single saddle-toroid being used to expand the synchrotron output; |
| Figure 15 | shows a plan view of the use of a single saddle-toroid; |
| Figure 16 | shows a cross sectional view of an array of micro toroids being used to expand and homogenise the synchrotron output; |
| Figure 17 | shows a plan view of the use of an array of micro toroids. |
| Figure 18 | shows a two element system in cross section; |
| Figure 19 | shows a two element system in plan view; |

| Figure 20 | shows an adjustable two mirror system; |
| Figure 21 a to e | shows an alternative method of manufacture of micro-toroidal optical components; and |
| Figure 22 | shows a series of results of ray tracing measurements. |

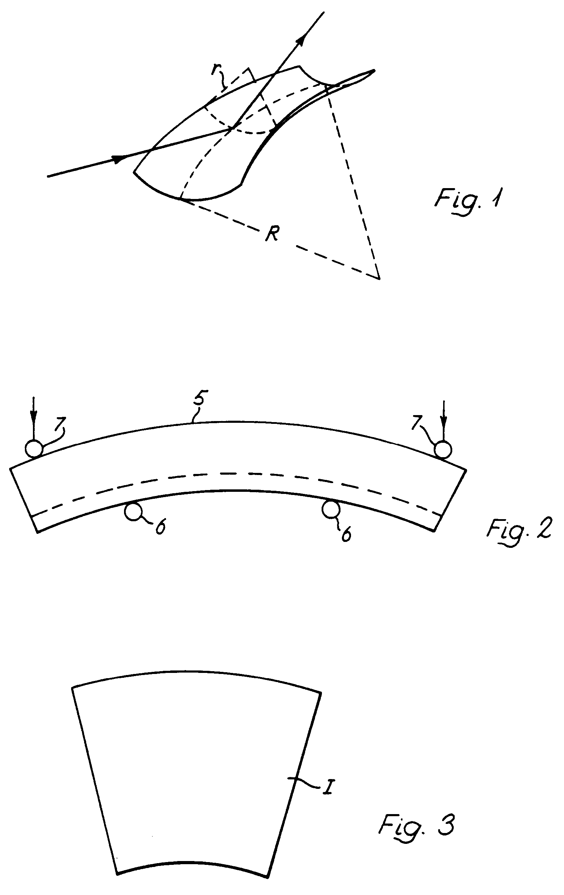

The simplest form of this invention is the use of a single saddle-toroid to collimate the beam in the horizontal plane and expand it in the vertical plane. A saddle-toroid has a concave (with respect to the incident radiation - indicated by the arrow) minor radius r, and a convex major radius R as shown in Figure 1. The minor radius is chosen so as to collimate the horizontal radiation by means of the formula:

$$\rho = 2u\sin\theta \quad (1)$$

where $\rho$ is the minor radius, u is the distance from the source point to the mirror and $\theta$ is the grazing angle of incidence at the mirror.

The major radius is chosen so as to increase the vertical divergence of the beam to make it sufficient to illuminate the required area at the exposure station, using the formula:

$$1/u + 1/v = 2/(R\sin\theta) \quad (2)$$

where u and v are the conjugates, R is the major radius and $\theta$ is the grazing incidence angle. Furthermore the conjugates are related by:

$$u/v = \text{(required exit divergence)/(incident divergence)} \quad (3)$$

The resultant saddle-toroid mirror is an optic that would be difficult and costly to manufacture by conventional grinding. However, by using the fact that if equal but opposite couples are applied to a prism, the resultant bend is circular between the points at which the couple is applied, a section of glass cylinder of the required minor radius can be bent to the required major radius, provided that radius is sufficiently large so that the stress of bending stays within the elastic limits of the glass. Figure 2 shows a section of tube 5 being bent by couples applied at either end via fixed supports 6 and adjustable supports 7. The adjustable supports 7 have been translated in the direction shown by the arrows.

An added advantage of having the major radius formed by bending is that it can be changed to achieve different exit divergences whilst in place in the beamline. This would allow different size areas to be illuminated depending on the production needs of the moment.

Such an optic still has three drawbacks:

a. The illumination patch I is crescent shaped, rather than rectangular, as shown in Figure 3.

b. Although the horizontal beam is collimated, the vertical beam has a divergence, which sets limits on the width of the finest line that can be drawn and places stricter constraints on the mask to recording medium separation. The ideal lithographic beam is collimated in both the vertical and horizontal beam.

c. The output beam is at an angle to the horizontal which complicates the exposure station design.

All three drawbacks can be eliminated by a two-toroid design. There are two possible two toroid designs: which have been named concentrating and diluting, for reasons which will become apparent.

In the first embodiment, a first mirror is a saddle-toroid with a concave minor radius (as seen by the beam) and a convex major radius. The second mirror is saddle toroid with a convex minor radius and a concave major radius.

The minor radii can be chosen by eliminating, to a first approximation, the crescent distortion of the illumination patch. This leads to the following formulae relating the two radii.

$$\rho_1 = \rho_2(1 + 4d/\rho_2 + 4(d/\rho_2)^2) \quad (4)$$

and

$$\rho2 = 4\rho_1((u\sin\theta)/(2u\sin\theta - \rho_1)^2 \quad (5)$$

where $\rho_1$ is the minor radius of the first mirror, $\rho_2$ is the minor radius of the second mirror, d is the vertical separation between the mirrors, u is the distance from the source point to the first mirror and $\theta$ is the angle of grazing incidence of the principle ray at both mirrors.

By solving equations 4 and 5 for given $\theta$, u and d, values of the minor radii are found that collimate the beam in the horizontal direction and provide a nearly rectangular illumination patch.

The major radii can be calculated from the lengths of the mirrors needed to obtain the required illumination area L2, the length of the second mirror is;

$$L2 = h/(\sin\theta) \quad (6)$$

where h is the height of the illuminated, path required and $\theta$ is the grazing angle of incidence.

L1 and L2, the lengths of the first and the second mirrors respectively are related by the equation:

$$L1/L2 = (u_2 - d/\sin\theta)/u_2 \quad (7)$$

where $u_2$ is the conjugate of the second mirror and d is the minimum distance between the mirrors.

$$L1 = u_1(\text{beam divergence})/\sin\theta \quad (8)$$

As u, $\theta$ and d are already known or assumed, L1 and L2 can be calculated and hence $u_2$ and R2.

R1 can then be calculated from the formula:

$$1/u + 1/v = 1/f \quad (9)$$

where u is known, $v = u_2 - d/\sin\theta$ and $f = Rl\sin\theta/2$.

These initial values of R1, R2, $\rho_1$ and $\rho_2$ for given $\theta$, d, h and u are the first approximations which correct to the first order. They can then be refined by optimisation ray tracing with an appropriate software package.

The design is called converging because it has the added benefit of producing a narrower horizontal beam than a single mirror horizontal collimator.

An alternate way of collimating the beam using two mirrors so that the illumination patch is rectangular is to use two toroids, but the first increases the horizontal divergence, which is then corrected by the second. The first mirror has both major and minor radiuses convex, while the second mirror has both radiuses concave, with respect to the incident beam. This design has the slight disadvantage, from a lithographic point of view, that the collimated horizontal beam is wider, and therefore less intense, than that which would be produced by a single mirror collimator.

The radiuses and conjugates can be calculated in a similar manner to that of the converging design, except that equation 4 becomes:

$$\rho_1 = \rho_2(1 - 4d/\rho_2 + 4(d/\rho_2)^2) \quad (10)$$

The other equations, 5 - 9 can then be used as before.

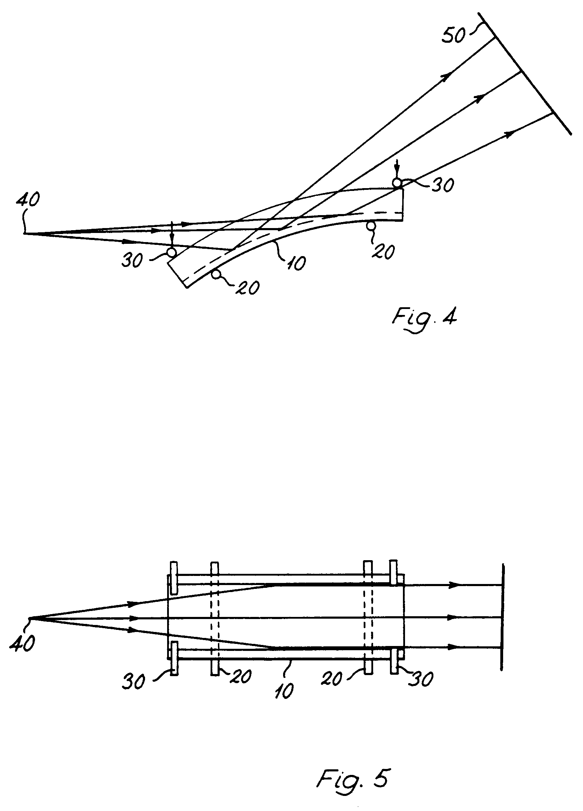

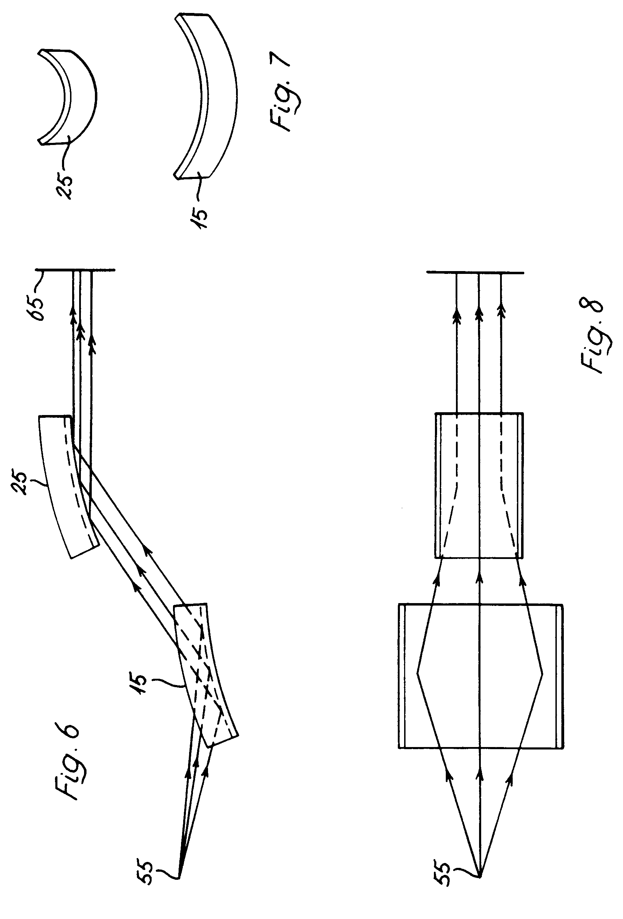

Referring to Figures 4 and 5 of the drawings a mirror comprises a section of a glass cylinder 10 of internal radius $\rho$, chosen to satisfy equation 1. The internal surface of the cylinder is coated with gold for optimum reflection of 1.0nm x-rays at a grazing incidence angle of 1.5°. This section of cylinder 10 is bent to form a saddle toroid of radius R by means of equal but opposite couples applied at either end of the cylinder by fixed supports 20 and adjustable supports 30. The couples are generated by moving the adjustable supports 30 in the direction indicated by the arrows on the drawing until the required radius is reached. The size of the radius R is calculated from the equation 2 and 3 as shown previously. The divergence of the beam emitted at the source point 40 depends on the characteristics of the synchrotron. The distance to the exposure station 50 and the required size of the exposure patch are needed in order to calculate the necessary divergence of the beam on reflection from the mirror.

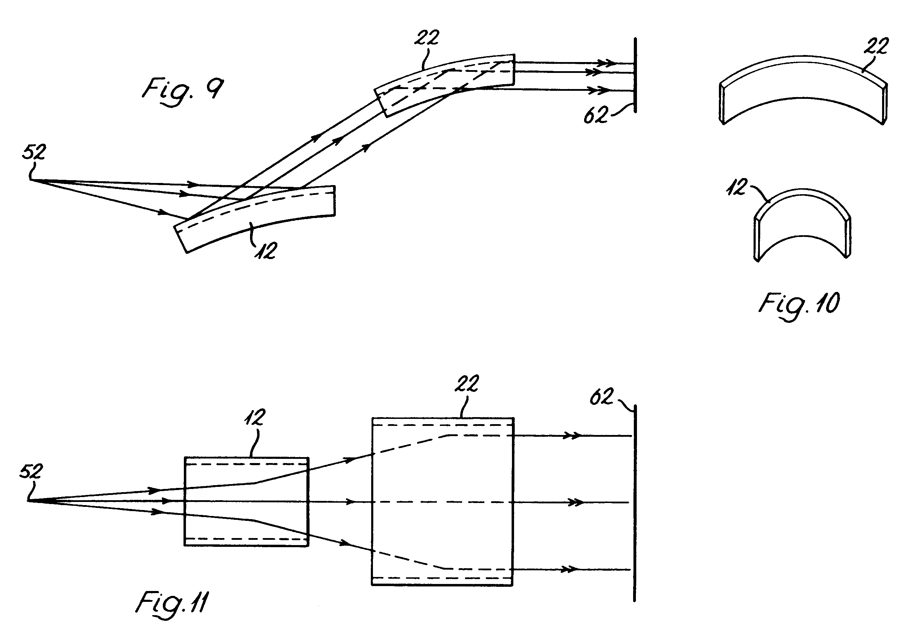

Referring to Figures 6 to 8 of the drawings, the mirrors comprise sections of glass cylinder 15 and 25 of internal radius $\rho_1$ and external radius $\rho_2$ respectively. These radii are chosen to satisfy equations 4 and 5, given previously. The internal surface of cylinder 15 and the external surface of cylinder 25 are coated with gold or other suitable material to optimise the reflectivity of the x-rays being used for the lithography, usually 1.0nm, at the appropriate grazing incidence angle, usually 1.5 degrees. The major radius R2 of the first mirror 12 is formed by bending it by applying equal but opposite couples at either end of the mirror 15 in the same way as for the single mirror example. The major radius R2 of the second mirror 25 is made similarly. The major radii are chosen to satisfy equations 6 - 9 given previously for the particular needs of the synchrotron source point 55 and the exposure station 65.

Referring to Figures 9 to 11 of the drawings, the mirrors comprise sections of glass cylinder 12 and 22 of internal radius $\rho_1$ and external radius $\rho_2$ respectively. These radii are chosen to satisfy equations 5 and 10, given previously. The internal surface of cylinder 12 and the external surface of cylinder 22 are coated with gold or other suitable material to optimise the reflectivity of the x-rays being used for the lithography, usually 1.0nm, at the appropriate grazing incidence angle, usually 1.5 degrees. The major radius R1 of the first mirror 12 is formed by bending it by applying equal but opposite couples at either end of the mirror 15 in the same way as for the single mirror example. The major radius R2 of the second mirror 22 is made similarly. The major radii are chosen to satisfy equations 6 - 9 given previously for the particular needs of the synchrotron source point 52 and the exposure station 62.

The mirrors in the invention could be made by conventional grinding or such innovative technique such as forming the appropriate toroid by bending a glass or ceramic section and then forming the glass to that shape, or even casting the shape in some appropriate material, such as epoxy, and coating the surface to give the required reflectivity.

The mirror shapes could either be symmetric toroids, achieved by bending with equal opposite couples, or off axis conics of revolution, achieved by bending with unequal couples. The ideal solution would suggest off axis conics of revolution but the symmetric toroids are very close approximations to these that they will suffice in most practical applications of the mirrors.

A further embodiment of the invention comprises a mirror which both expands the beam of radiation and homogenises it. Previously it has been shown that the use of a saddle toroid or a combination of a cylinder and a saddle toroid can provide a horizontally collimated, vertically expanded beam of use to lithography. However these mirrors required a uniform input beam to produce a uniform output beam. If used with a gaussian-profiled synchrotron beam they would produce illumination patches which had a gaussian profile in the vertical direction. By making a mirror which is not a single but a large number (50 to 1000) of micro saddle-toroids, a uniform output beam that is expanded in the vertical plane and collimated in the horizontal can be produced. Each element of the array of micro saddle-toroids spreads a small section of the input beam over the entire output patch. The result of the spreading of all the small sections is a uniformly illuminated patch, whose overall shape is closely related to the illumination patch produced by a single saddle toroid of the same minor radius, but whose major radius is larger in proportion to the number of micro toroids. This array of micro toroids can be readily produced by a process involving the melting of an exact volume of a polymer or other suitable material on a defined pedestal. Surface tension produces a portion of a sphere in the case of a circular pedestal, a cylinder in the case of a line pedestal and a saddle toroid in the case of a line pedestal on a concave cylindrical surface.

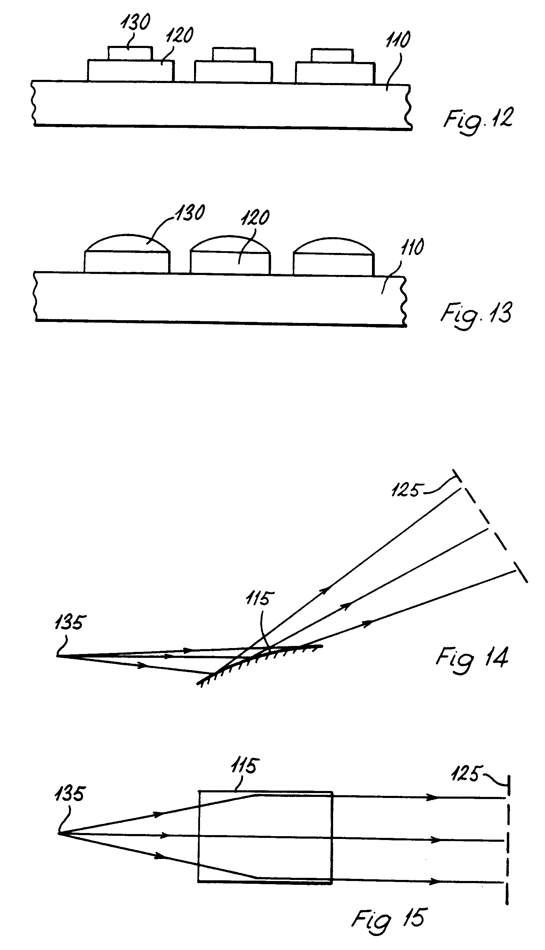

Referring to Figures 12 to 17, an array of micro toroids is manufactured on a glass or other suitable cylindrical substrate 110, by putting down two layers of suitable polymers such as a 1μm thick layer of polyimide 120 and a 2μm thick layer of novalak resist 130. These polymers are machined into strips running perpendicular to the axis of the cylindrical substrate 110 either by standard lithographic techniques, or by uv-photoablation using an excimer laser. The excimer laser allows the use of much thicker resists than lithography and easier control of the depth of the machining. The whole array is then heated in an oven to a temperature at which the novalak resist 130 becomes molten, but the pedestal 120 does not. The resist 130 flows to cover the entire pedestal 120, with its top surface assuming a cylindrical shape under surface tension. After cooling and post baking, the top is coated with gold or other suitable x-ray reflecting material.

Figure 14 shows single saddle-toroid 115, having a concave minor radius and a convex major radius, expanding the output from a synchrotron source 135 in the vertical direction, whilst collimating it in the horizontal direction, to produce the required patch of illumination 125. However, although the shape of this patch 125 is usable, it will have the same gaussian profile in the vertical direction as the beam 135 that it expanded. It could only be used in lithography if a considerable portion of the radiation from the source 135 were discarded.

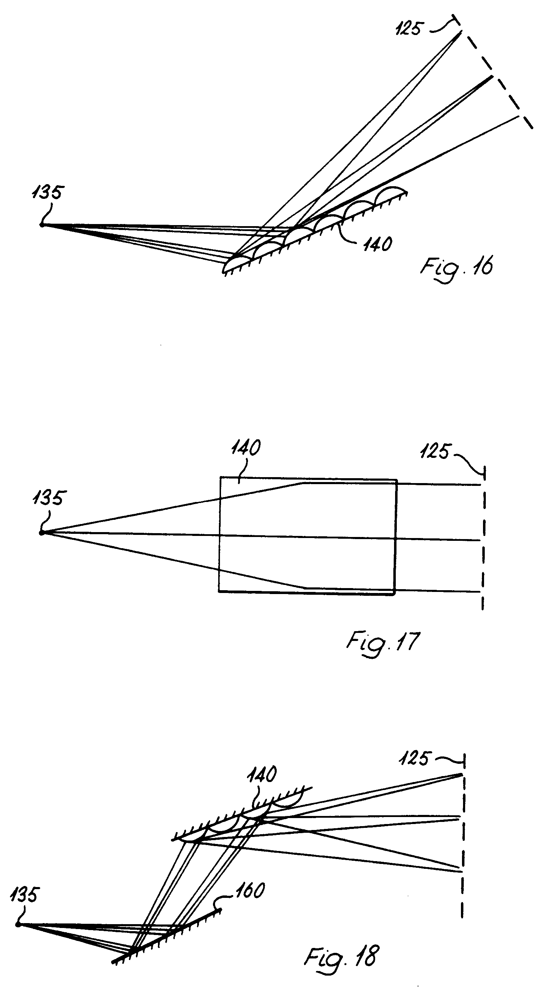

By using the array of micro toroids 140 as shown in cross section in Figure 16 and in plan in Figure 17, the synchrotron beam 135 can be both expanded to fill the required patch 125, but will also illuminate the patch in a uniform way, using all the radiation from the synchrotron. In effect the time-averaging of scanning mirror has been exchanged for a space-averaging using an array of reflections, each of which spreads a part of the synchrotron beam over the entire surface to be illuminated.

The substrate 110 is part of a cylinder whose minor radius has been chosen to collimate the beam in the horizontal direction. The major radius of the micro toroids is chosen to spread the radiation over the entire illumination surface.

The illumination patch produced by either a single saddle-toroid or a single array of micro saddle-toroid is characteristically crescent shaped. In practice this would mean that 30-50% of the synchrotron radiation would fall outside a rectangle and so not be used. A two mirror system, consisting of a convex cylinder and a saddle toroid can be used to produce a rectangular illumination patch, as described above.

By using an array of saddle toroid as the second element, the rectangular output patch can be uniformly illuminated even if the input to the system is non-uniform.

Referring to Figures 18 to 20, the minor radii of the two elements 160 and 140 is related by the following two equations, derived from the formula:

$$\rho_2 = n\rho_2 \quad (11)$$
$$\rho_1 = (u(n + 1)\sin\alpha + d + sqrt((u(n + 1)\sin\alpha + d) * * 2 - 4ndu\sin\alpha))/n \quad (12)$$

where $\rho_1$ is the minor radius of the first element 160, $\rho_2$ is the minor radius of the second element 140, n is the ratio of the two radii, u is the distance from the source to the first element, a is the grazing incidence angle of the principal ray at both surfaces and d is the vertical separation of the two elements, measured perpendicularly to the axis.

By varying n, the ratio of the two minor radii, and using a computer ray tracing program, it is possible to find a value of n that gives a rectangular illumination patch.

The major radius of the second element can also be chosen by computer ray tracing.

The second element 140 is constructed as discussed before, and as in the one element design creates a uniform illumination patch 125. However the shape of the patch is now rectangular, with 100% of the synchrotron radiation being usable, so that as long as the second mirror is 70% reflecting or better the two element system is more efficient.

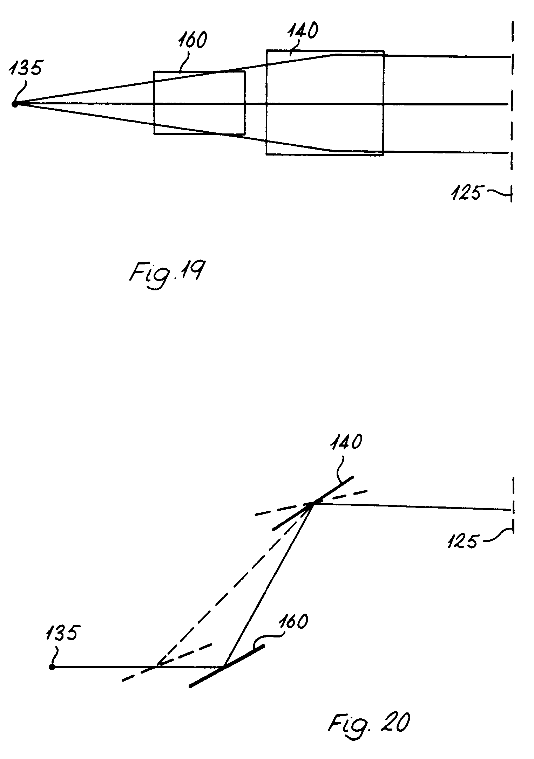

Figure 20 show a cross section of a two element system in which the distance between the convex cylinder 160 and the array of micro saddle-toroids 140 is varied by altering the angle of both and moving the cylinder in the line of the original synchrotron beam. By reducing the separation and changing the angle without changing the minor radius the width of the illuminated patch can be varied by 20% without significantly altering the rectangular shape. By a simple motion, with rotation about the pole of the array 140, the system has the added advantage of keeping the input and exit beams at a constant angle.

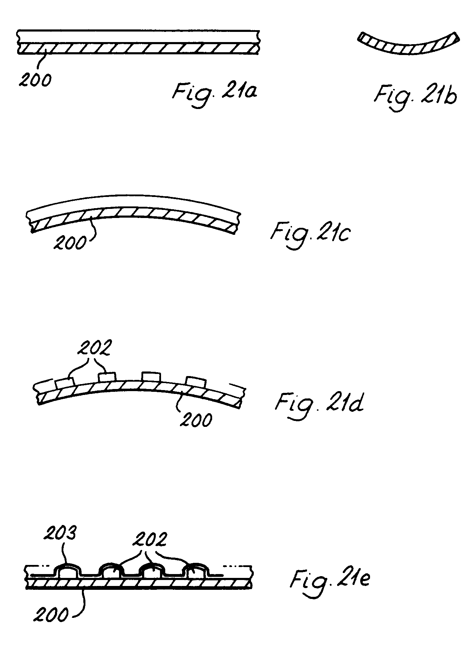

An alternative method of manufacture of microarrays of saddle toroids is illustrated in Figure 21a to 21e.

A substrate 200 that is a section of a cylinder is first bent to form a saddle toroid shown in section in Figure 21b. A thin layer 201 of polymer is then applied to the bent substrate, and whilst the substrate is still bent, is separated into a series of strips 202 running at right angles to the major axis of the substrate. This patterning may be created by lithography, uv ablation or other suitable method of cutting thin strips in material (spark erosion etc. depending on the nature of the coating). Once it is patterned, the couple causing the substrate to bend is then released, allowing the substrate to revert to its shape as a section of a cylinder. In doing so it now exerts a force on the top layer that was applied when it was bent, thus forming a plurality of micro-saddle toroids. The whole structure is then coated with a layer of gold 203 and used in the same manner as the micro array formed by melting.

Ray traces were carried out for a variety of combinations of minor radii, in order to optimise the output beam.

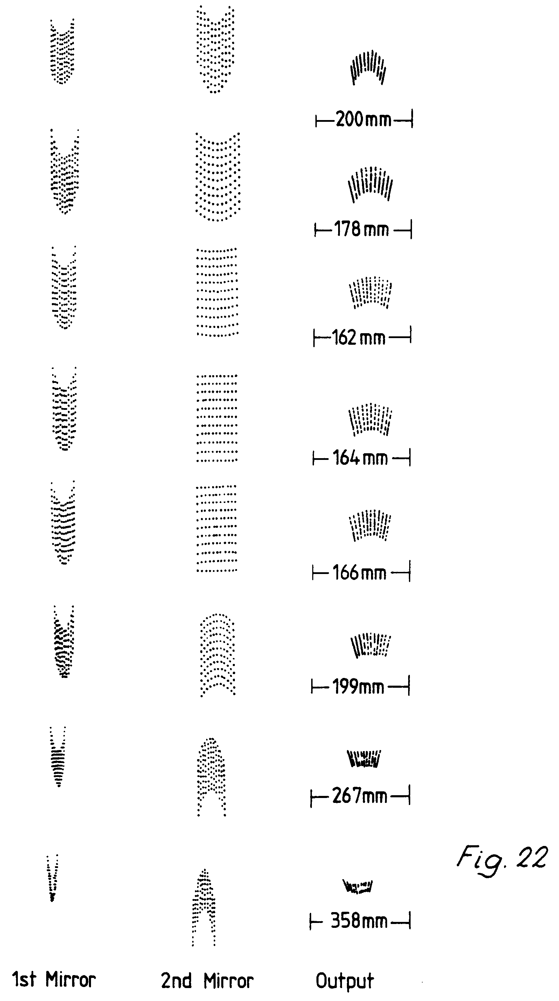

Typical results are shown in Fig. 22, which shows the scale of each spot diagram and the shape of the beam at the plane of the lithographic mask.

The ray tracing arrangement for the results shown was to have a source point, radiating uniformly in all directions. One meter away was an aperture measuring ±7.4mm in the horizontal direction. This slit was then uniformly filled, creating a first approximation to synchrotron radiation. (The same slit aperture was used in the single cylinder and single toroid ray traces referred to previously). The centre of the first toroid was placed a further 1.7m downstream of the slit. The position of the second toroid was determined by the vertical separation d. This was chosen as 30mm, so that the separation between the line of the incoming beam and the exiting beam was 60mm. This allows the positioning of the statutory lead or uranium safety beamstop. The grazing angle of incidence was 20mR (1.5°). This means that the second mirror centre was 1145.6mm from the first. The lithography station was placed a further 7m downstream.

The parameters for the spot diagrams shown in Figure 22 are listed in Table 1.

In these examples the first element was a cylindrical mirror and the second was bent into a saddle-toroid, with a major radius of 80,000mm.

The shape of the lithography mask illumination patch varied from a crescent to a near rectangle. At the optimum values the shape was such that 86% of it fell within a usable rectangle.

## Table 1. Cylinder-toroid parameters

| number | n | r (mm) | r' (mm) |
|---|---|---|---|
| 1 (top) | −0.4 | 413 | 165 |
| 2 | −0.6 | 251 | 150 |
| 3 | −0.66 | 222 | 146 |
| 4 | −0.68 | 213 | 145 |
| 5 | −0.70 | 205 | 144 |
| 6 | −0.80 | 172 | 138 |
| 7 | −1.00 | 127 | 127 |
| 8 (bottom) | −1.20 | 98 | 118 |

This solution was a diluting one, in that the first mirror expands the beam and the second causes it to reconverge. This means that the final intensity of the beam in the horizontal was slightly less than if the same fan of synchrotron radiation had been reflected by a single mirror. Compared with letting the beam expand naturally to a final point 10m from the tangent point, a single toroid or cylinder condenses the illumination by a factor of 3.7, while this two mirror system only condenses it by a factor of 2.2. That combined with the greater reflection losses of this system, 56% total reflectivity compared to 75% for a single surface, mean that the total usable fraction of light was down by about 21% from that of a single saddle-toroid system.

The second mirror, the toroid, could be replaced by a saddle-toroid array mirror to give uniformity of illumination, but the throughput would be slightly less, due to the elements of the saddle-toroid array not completely covering the substrate. This would give an added loss of between 1 to 4%, depending on the details of the saddle-toroid array design.

As an alternative to using a cylindrical section for the curves, some other conic section could be employed. In particular, we have found that advantageous properties result from using an ellipsoid of rotation for the minor radius curve.

An alternative to the use of photoresist or glass coatings to form the multi-toroid arrays is to use a metal/metal arrangement where a high melting point substrate is coated with a low melting point metal which is then slit longitudinally and then melted to form the toroidal surfaces.

A further alternative is to vary the radius of each saddle element by depositing a tapered layer which is then slit and melted.

In a yet further embodiment a multi-layer coating is used instead of the reflective metal such as gold.

## Claims

1. An optical device adapted for use as a grazing incidence collimator characterised in that it includes at least one reflective surface (115) of saddle-toroid form.

2. An optical device adapted for use as a grazing incidence collimator as claimed in claim 1 characterised in that it comprises a pair of reflective components (15,25;12,22) wherein each of said components includes at least one reflective surface of saddle-toroid form.

3. An optical device adapted for use as a grazing incidence collimator as claimed in claim 2 characterised in that the first (15) of said pair of reflective components (15,25) has a reflective surface with a concave minor radius and a convex major radius and the second (25) of said pair of reflective components (15,25) has a reflective surface with a convex minor radius and a concave major radius.

4. An optical device adapted for use as a grazing incidence collimator as claimed in claim 2 characterised in that both the major and the minor radii of the reflective surface of the first (12) of said pair of reflective components (12,22) are convex and both the major and the minor radii of the reflective surface of the second (22) of said pair of reflective components (12,22) are concave.

5. An optical device adapted for use as a grazing incidence collimator as claimed in claim 2 characterised in that the second of said pair of reflective components comprises an array (140) of microtoroids.

6. An optical device adapted for use as a grazing incidence collimator as claimed in claim 5 characterised in that said array includes at least fifty microtoroids.

7. An optical device adapted for use as a grazing incidence collimator as claimed in claim 6 characterised in that said array includes between fifty and one thousand microtoroids.

8. An optical device adapted for use as a grazing incidence collimator as claimed in any one of claims 5 to 7 characterised in that said array includes successive microtoroids having different minor radii.

9. An optical device adapted for use as a grazing incidence collimator as claimed in any one of claims 2 to 8 characterised in that it includes means for simultaneous changing the relative spacing and orientation of the first and second of said pair of reflective components.

10. An optical device adapted for use as a grazing incidence collimator as claimed in any one of the preceding claims 1 to 9 characterised in that it incorporates means for varying the curvature of at least one reflective surface.

11. An optical device adapted for use as a grazing incidence collimator as claimed in claim 10 characterised in that the means for varying the curvature comprises means for applying couples of opposite sign to opposite ends of a component having a reflective surface.

12. A method of manufacture of optical components characterised in that it comprises the steps of forming a base member comprising a concave cylindrical substrate (110,120) having a surface layer (130) divided into an array of linear strip-like members perpendicular to the axis of said cylindrical substrate, applying heat to melt the surface layer and applying a reflective coating to said surface layer.

13. A method of manufacture of optical components as claimed in claim 12 characterised in that a substrate comprising a relatively high melting point material is coated with a surface layer of a relatively low melting point material, said surface layer is separated into an array of strip-like members and said substrate and said surface layer are heated to a temperature intermediate said relatively high and said relatively low melting points.

14. A method of manufacture of optical components as claimed in claim 13 characterised in that said surface layer is tapered in section.

15. A method of manufacture of optical components as claimed in either claim 13 or 14 characterised in that said surface layer is of metal.

16. A method of manufacture of optical components as claimed in either claim 13 or 14 characterised in that said surface layer is of polymeric material.

17. A method of manufacture of optical components as claimed in claim 16 characterised in that said surface layer is of novolak resist.

18. A method of manufacture of optical components as claimed in either claim 16 or 17 characterised in that said surface layer is subsequently coated with a reflective coating.

19. A method of manufacture of optical components as claimed in claim 18 characterised in that said surface layer is subsequently coated with a multilayer reflective coating.

20. A method of manufacture of optical components as claimed in claim 18 characterised in that said surface layer is subsequently coated with gold.

21. A radiation source incorporating an optical device in accordance with any one of claims 1 to 10.

22. A synchrotron incorporating an optical device in accordance with any one of claims 1 to 10.


**Patentansprüche**

1. Optische Vorrichtung ausgelegt zur Verwendung als Kollimator für einen streifenden Einfall, dadurch gekennzeichnet, daß sie zumindest eine reflektierende Oberfläche (115) in Sattel-Toroidform aufweist.

2. Optische Vorrichtung ausgelegt zur Verwendung als Kollimator für einen streifenden Einfall nach Anspruch 1, dadurch gekennzeichnet, daß sie ein Paar reflektierende Bauteile (15, 25; 12 22) umfaßt, wobei jedes der Bauteile zumindest eine reflektierende Oberfläche in Sattel-Toroidform aufweist.

3. Optische Vorrichtung ausgelegt zur Verwendung als Kollimator für einen streifenden Einfall nach Anspruch 2, dadurch gekennzeichnet, daß das erste Teil (15) des Paares reflektierender Bauteile (15, 25) eine reflektierende Oberfläche mit einem konkaven Nebenradius und einem konvexen Hauptradius und das zweite Teil (25) des Paares reflektierender Bauteile (15, 25) eine reflektierende Oberfläche mit einem konvexen Nebenradius und einem konkaven Hauptradius aufweist.

4. Optische Vorrichtung ausgelegt zur Verwendung als Kollimator für einen streifenden Einfall nach Anspruch 2, dadurch gekennzeichnet, daß sowohl die Haupt- als auch die Nebenradien der reflektierenden Oberfläche des ersten Teils (12) des Paares reflektierender Bauteile (12, 22) konvex sind und sowohl die Haupt- als auch die Nebenradien der reflektierenden Oberfläche des zweiten Teils (22) des Paares reflektierender Bauteile (12, 22) konkav sind.

5. Optische Vorrichtung ausgelegt zur Verwendung als Kollimator für einen streifenden Einfall nach Anspruch 2,
dadurch gekennzeichnet, daß das zweite Teil des Paares reflektierender Bauteile eine Anordnung (140) von Mikrotoroiden aufweist.

6. Optische Vorrichtung ausgelegt zur Verwendung als Kollimator für einen streifenden Einfall nach Anspruch 5,
dadurch gekennzeichnet, daß die Anordnung mindestens fünfzig Mikrotoroide umfaßt.

7. Optische Vorrichtung ausgelegt zur Verwendung als Kollimator für einen streifenden Einfall nach Anspruch 6,
dadurch gekennzeichnet, daß die Anordnung zwischen fünfzig und tausend Mikrotoroide umfaßt.

8. Optische Vorrichtung ausgelegt zur Verwendung als Kollimator für einen streifenden Einfall nach einem der Ansprüche 5 bis 7,
dadurch gekennzeichnet, daß die Anordnung aufeinanderfolgende Mikrotoroide mit verschiedenen Nebenradien aufweist.

9. Optische Vorrichtung ausgelegt zur Verwendung als Kollimator für einen streifenden Einfall nach einem der Ansprüche 2 bis 8,
dadurch gekennzeichnet, daß sie eine Vorrichtung zum gleichzeitigen Verändern des relativen Abstands und zur Orientierung des ersten und zweiten Teils des Paares reflektierender Bauteile umfaßt.

10. Optische Vorrichtung ausgelegt zur Verwendung als Kollimator für einen streifenden Einfall nach einem der vorhergehenden Ansprüche 1 bis 9,
dadurch gekennzeichnet, daß sie eine Vorrichtung zum Variieren der Krümmung zumindest einer reflektierenden Oberfläche umfaßt.

11. Optische Vorrichtung ausgelegt zur Verwendung als Kollimator für einen streifenden Einfall nach Anspruch 10,
dadurch gekennzeichnet, daß die Vorrichtung zum Variieren der Krümmung eine Vorrichtung zum Anlegen von Paaren gegenstätzlicher Vorzeichen an entgegengesetzten Enden eines Bauteils mit einer reflektierenden Oberfläche umfaßt.

12. Verfahren zur Herstellung optischer Bauteile,
dadurch gekennzeichnet, daß es die Schritte zum Formen eines Basisteils, das ein konkaves zylindrisches Substrat (110, 120) mit einer Oberflächenschicht (130), die in eine Anordnung linearer streifenartiger Teile aufgeteilt ist, die senkrecht zur Achse des zylindrischen Substrats angeordnet sind, die Anwendung von Wärme zum Schmelzen der Oberflächenschicht und das Anbringen eines reflektierenden Überzugs auf die Oberflächenschicht umfaßt.

13. Verfahren zur Herstellung optischer Bauteile nach Anspruch 12,
dadurch gekennzeichnet, daß ein Substrat, das ein Material mit einem relativ hohen Schmelzpunkt umfaßt, mit einer Oberflächenschicht aus einem Material mit einem relativ niedrigen Schmelzpunkt beschichtet wird, wobei die Oberflächenschicht in eine Anordnung streifenartiger Teile aufgeteilt ist und das Substrat und die Oberflächenschicht auf eine Temperatur erwärmt werden, die zwischen dem relativ hohen und dem relativ niedrigen Schmelzpunkt liegt.

14. Verfahren zur Herstellung optischer Bauteile nach Anspruch 13,
dadurch gekennzeichnet, daß die Oberflächenschicht im Schnitt zugespitzt ist.

15. Verfahren zur Herstellung optischer Bauteile nach Anspruch 13 oder 14,
dadurch gekennzeichnet, daß die Oberflächenschicht aus Metall besteht.

16. Verfahren zur Herstellung optischer Bauteile nach Anspruch 13 oder 14,
dadurch gekennzeichnet, daß die Oberflächenschicht aus einem polymeren Material besteht.

**17.** Verfahren zur Herstellung optischer Bauteile nach Anspruch 16,
dadurch gekennzeichnet, daß die Oberflächenschicht aus Novolakresist besteht.

**18.** Verfahren zur Herstellung optischer Bauteile nach Anspruch 16 oder 17,
dadurch gekennzeichnet, daß die Oberflächenschicht nachträglich mit einem reflektierenden Überzug beschichtet wird.

**19.** Verfahren zur Herstellung optischer Bauteile nach Anspruch 18,
dadurch gekennzeichnet, daß die Oberflächenschicht nachträglich mit einem vielschichtigen reflektierenden Überzug beschichtet wird.

**20.** Verfahren zur Herstellung optischer Bauteile nach Anspruch 18,
dadurch gekennzeichnet, daß die Oberflächenschicht nachträglich mit Gold beschichtet wird.

**21.** Strahlungsquelle, die eine optische Vorrichtung nach einem der Ansprüche 1 bis 10 umfaßt.

**22.** Synchroton, das eine optische Vorrichtung nach einem der Ansprüche 1 bis 10 umfaßt.

## Revendications

**1.** Dispositif optique adapté à être utilisé en tant que collimateur à incidence rasante, caractérisé en ce qu'il comprend au moins un surface réfléchissante (115) en forme de selle toroïdale.

**2.** Dispositif optique adapté à être utilisé en tant que collimateur à incidence rasante selon la revendication 1, caractérisé en ce qu'il comprend une paire de composants réfléchissants (15, 25; 12, 22), chacun desdits composants comprenant au moins une surface réfléchissante en forme de selle toroïdale.

**3.** Dispositif optique adapté à être utilisé en tant que collimateur à incidence rasante selon la revendication 2, caractérisé en ce que le premier (15) de ladite paire de composants réfléchissants (15, 25) comporte une surface réfléchissante avec un rayon mineur concave et un rayon majeur convexe et le second (25) de ladite paire de composants réfléchissants (15, 25) comprend une surface réfléchissante avec un rayon mineur convexe et un rayon majeur concave.

**4.** Dispositif optique adapté à être utilisé en tant que collimateur à incidence rasante selon la revendication 2, caractérisé en ce que les deux rayons majeur et mineur de la surface réfléchissante du premier (12) de ladite paire de composants réfléchissants (12, 22) sont convexes, et les deux rayons majeur et mineur de la surface réfléchissante du second (22) de ladite paire de composants réfléchissants (12, 22) sont concaves.

**5.** Dispositif optique adapté à être utilisé en tant que collimateur à incidence rasante selon la revendication 2, caractérisé en ce que le second de ladite paire de composants réfléchissants comprend un réseau (140) de microtoroïdes.

**6.** Dispositif optique adapté à être utilisé en tant que collimateur à incidence rasante selon la revendication 5, caractérisé en ce que ledit réseau comprend au moins cinquante microtoroïdes.

**7.** Dispositif optique adapté à être utilisé en tant que collimateur à incidence rasante selon la revendication 6, caractérisé en ce que ledit réseau comprend entre cinquante et mille microtoroïdes.

**8.** Dispositif optique adapté à être utilisé en tant que collimateur à incidence rasante selon l'une quelconque des revendications 5 à 7, caractérisé en ce que ledit réseau comprend des microtoroïdes successifs présentant des rayons mineurs différents.

**9.** Dispositif optique adapté à être utilisé en tant que collimateur à incidence rasante selon l'une quelconque des revendications 2 à 8, caractérisé en ce qu'il comprend des moyens pour modifier simultanément l'espacement et l'orientation relatifs du premier et du second de ladite paire de composants réfléchissants.

**10.** Dispositif optique adapté à être utilisé en tant que collimateur à incidence rasante selon l'une quelconque des revendications précédentes 1 à 9, caractérisé en ce qu'il incorpore de moyens pour modifier la courbure d'au moins une surface réfléchissante.

11. Dispositif optique adapté à être utilisé en tant que collimateur à incidence rasante selon la revendication 10, caractérisé en ce que les moyens pour modifier la courbure comprennent des moyens pour appliquer des couples de signe opposé sur les extrémités opposées d'un composant présentant une surface réfléchissante.

12. Procédé de fabrication de composants optiques, caractérisé en ce qu'il comprend les étapes consistant à former un élément de base comprenant un substrat cylindrique concave (110, 120) comportant une couche de surface (130) divisée en un réseau d'éléments linéaires en forme de bande perpendiculaires à l'axe dudit substrat cylindrique, à appliquer de la chaleur pour faire fondre la couche de surface et appliquer un revêtement réfléchissant sur ladite couche de surface.

13. Procédé de fabrication de composants optiques selon la revendication 12, caractérisé en ce qu'un substrat comprenant un matériau à point de fusion relativement élevé est revêtu avec une couche de surface en un matériau à point de fusion relativement bas, ladite couche de surface est séparée en une rangée d'éléments en forme de bande, et ledit substrat et ladite couche de surface sont chauffés à une température intermédiaire entre lesdits points de fusion relativement élevé et relativement bas.

14. Procédé de fabrication de composants optiques selon la revendication 13, caractérisé en ce que ladite couche de surface est de section effilée.

15. Procédé de fabrication de composants optiques selon la revendication 13 ou 14, caractérisé en ce que ladite couche de surface est en métal.

16. Procédé de fabrication de composants optiques selon la revendication 13 ou 14, caractérisé en ce que ladite couche de surface est en un matériau polymère.

17. Procédé de fabrication de composants optiques selon la revendication 16, caractérisé en ce que ladite couche de surface est en vernis novolaque.

18. Procédé de fabrication de composants optiques selon la revendication 16 ou 17, caractérisé en ce que ladite couche de surface est revêtue par la suite avec un revêtement réfléchissant.

19. Procédé de fabrication de composants optiques selon la revendication 18, caractérisé en ce que ladite couche de surface est revêtue par la suite avec un revêtement réfléchissant multicouche.

20. Procédé de fabrication de composants optiques selon la revendication 18, caractérisé en ce que ladite couche de surface est revêtue par la suite avec de l'or.

21. Source de rayonnement incorporant un dispositif optique selon l'une quelconque des revendications 1 à 10.

22. Synchrotron incorporant un dispositif optique selon l'une quelconque des revendications 1 à 10.

Fig. 1

Fig. 2

Fig. 3

Fig. 4

Fig. 5

13

Fig. 6

Fig. 7

Fig. 8

EP 0 403 561 B1

Fig. 9

Fig. 10

Fig. 11

EP 0 403 561 B1

Fig. 12

Fig. 13

Fig 14

Fig 15

Fig. 16

Fig. 17

Fig. 18

Fig.19

Fig. 20

Fig. 21a

Fig. 21b

Fig. 21c

Fig. 21d

Fig. 21e

├─200mm─┤

├─178mm─┤

├─162mm─┤

├─164mm─┤

├─166mm─┤

├─199mm─┤

├─267mm─┤

*Fig. 22*

├─358mm─┤

1st Mirror    2nd Mirror    Output